# EUROPEAN PATENT SPECIFICATION

(11) **EP 3 048 867 B1**
(45) Date of publication and mention of the grant of the patent: **07.03.2018**
(21) Application number: 16150923.7
(22) Date of filing: 12.01.2016
(51) Int. Cl.: H05K 5/00

(54) **COVER ATTACHMENT STRUCTURE OF CASE**
ABDECKUNGSBEFESTIGUNGSSTRUKTUR EINES GEHÄUSES
STRUCTURE DE FIXATION DE COUVERCLE DE BOÎTIER

(30) Priority: 23.01.2015 JP 2015011615
(43) Date of publication of application: 27.07.2016
(73) Proprietor: NGK Spark Plug Co., Ltd., Nagoya-shi, Aichi 467-8525 (JP)
(72) Inventor: KAWAGISHI, Wataru, Nagoya-shi, Aichi 467-8525 (JP); KODA, Takashi, Nagoya-shi, Aichi 467-8525 (JP)
(74) Representative: J A Kemp

(56) References cited:
- WO-A1-2014/188691
- WO-A2-2013/098377
- JP-A- H08 236 964
- US-B1- 6 178 094

## Description

The present invention relates to a case (housing) that has a case body for containing contents, such as a circuit board, and that is closable by attaching a cover to an opening for installing the contents, and in particular, to a cover attachment structure of the case.

For example, an electronic control unit (ECU), which is disposed in an engine compartment of an automobile, includes a circuit board (hereinafter, referred to as "a board") on which a large number of electronic components are mounted; a case body that is made of a resin and that contains contents (components), such as the board; a cover that closes an opening in the case body for installing the contents; and the like. Examples of such a cover include a cover through which a connector terminal protrudes to the outside of the cover. The connector terminal is electrically connected to a terminal of a circuit board that is fixed to the back surface of the cover. After the cover has closed the opening of the case, a mating (female) connector terminal is fitted onto and connected to the connector terminal of the cover, which protrudes to the outside. To protect the circuit board and other contents of the case, it is required that the cover be securely attached to the case so as to be resistant to vibration and impact and that the cover would not be separated and removed from the case due to an external force that is applied to the cover when, for example, disconnecting a mating connector terminal.

Examples of known cover attachment structures for satisfying such requirements include the following. In one example, an annular rubber packing is disposed on a portion of a case body at the periphery of an opening for installing components. The cover is fixed to the portion of the case body at the periphery of the opening by driving a screw into the portion of the case body so that a peripheral portion of the cover presses the packing (see Japanese Unexamined Patent Application Publication No. 2003-258450 and Japanese Unexamined Patent Application Publication No. 2006-049701). This structure has a merit of being watertight but also has the following demerit. For example, if the shape of the portion of the case body, including the opening to which the cover is to be attached, is a tubular shape with a rectangular (square or rectangular) cross section, it is at least necessary to fix the cover to a rectangular peripheral portion of the case body by driving screws into the peripheral portion at three positions or four positions near the four corners. Therefore, it is necessary to use at least three screws and to perform a step of driving the three screws, so that the production cost and the assembly cost of the case may increase.

Another example of the cover attachment structure (means) is as follows. A case body is made of plastic (insulating resin) and includes a cover attachment rectangular frame that is tubular (socket-shaped), that has a rectangular inner cross section, and that is elastically deformable. A cover, which has a rectangular shape corresponding to the inner cross section, can be pressed into the cover attachment rectangular frame by a predetermined distance from an opening at an end of the case body to be attached to a cover attachment position. In this structure, a stopper for preventing excessive insertion of the cover is disposed in the cover attachment rectangular frame. Moreover, engagement portions (claws, protrusions, or the like), for preventing forward movement and separation of the cover attached to the case body, are disposed on one of two pairs of opposite inner wall surfaces of the cover attachment rectangular frame at positions between the cover attachment position and the opening. The engagement portions protrude (or bulge) inward from the opposite inner wall surfaces so that the minimum distance therebetween before the cover is attached is smaller than a corresponding side-to-side dimension (outside dimension) of the cover. In this structure, in order to allow the cover to be easily pressed (press-fitted) into the case body by reducing resistance against the cover due to the presence of the engagement portions, the distances between two pairs of opposite inner wall surfaces, which face each other vertically or horizontally, at the cover attachment position in the cover attachment rectangular frame are slightly greater than the corresponding side-to-side dimensions of the cover.

Thus, because the cover can be pressed into the case body while deforming the engagement portions, which protrude inward, and the surrounding portions of the case body, the cover can be attached to the case body with a comparatively small pressing force. Accordingly, the cover can be attached easily and rapidly. The two engagement portions, which face each other, include inclined portions the distance between which decreases in a direction away from the opening, so that the cover can be easily pressed into the case body. With this structure, when pressing the cover into the case body, the case body can be easily deformed by pressing edges of the cover against the inclined portions of the engagement portions so as to increase the distance between a pair of inner wall surfaces. When the cover has passed over the inclined portions, the cover is attached to a position (cover attachment position) between the stopper and the engagement portions. At the same time, as the cover attachment rectangular frame (elastically) returns to its original shape, the edges of the cover are structurally stopped by the engagement portions with a predetermined amount of engagement and thereby separation of the cover in the forward direction is prevented. It is difficult to attach the cover so as to be watertight by means of only this attachment structure. However, because the cover can be attached to the case body by using deformation of the case body (cover attachment rectangular frame) due to pressing of the cover and return to the original shape, it is not necessary to use other components, such as a screw. Moreover, the cover can be easily and rapidly attached to the case body by simply pressing (or press-fitting) the cover into the case body. Therefore, this attachment structure is preferable in a case where watertightness can be achieved by other means.

In the aforementioned cover attachment structure, with which the cover is pressed into the case body, the distances between two pairs of opposite inner wall surfaces, which face each other vertically or horizontally, at the cover attachment position in the cover attachment rectangular frame are each slightly greater than the corresponding side-to-side dimension of the cover. Therefore, the cover is attached to the case body in a so-called clearance-fit state, so that the cover may become slightly loose after being attached. Moreover, prevention of movement of the cover toward the opening (forward movement) and separation of the cover depends only on the amount (dimension) of engagement between the engagement portions and the edges of the cover. Accordingly, the cover may not be securely attached to the case body by only pressing the cover into the case body.

It may be possible to securely attach the cover to the case body by increasing the inward protruding lengths of the engagement portions. However, doing so may increase the risk that the engagement portions become broken or cracked. Moreover, even by doing so, it is difficult to prevent slight looseness of the cover. Therefore, instead of increasing the inward protruding lengths of the engagement portions, the distance between the two pairs of opposite inner wall surfaces, which face each other vertically or horizontally, at the cover attachment position in the cover attachment rectangular frame may each be made smaller than or equal to the corresponding side-to-side dimension of the cover. That is, when the cover is attached to the case body, the cover is tightly fitted into or attached to the cover attachment rectangular frame without clearances in vertical and horizontal directions.

In this case, however, it is difficult to attach the cover to the case body because it is necessary to press the cover with a considerably large force. In particular, regarding the inner wall surfaces on which the engagement portions are disposed, when pressing the cover, it is necessary to additionally increase the distance between the inner wall surfaces locally due to the presence of the engagement portions. Accordingly, such a structure, with which the cover is tightly fitted into the case body both in the vertical and horizontal directions, has a problem in that there is a risk of occurrence of breakage or cracking of the engagement portions or the cover attachment rectangular frame when the cover is being pressed into the case body or after the cover has been attached to the case body.

US-B1-6,178,094 discloses a case for mounting a circuit board on which the precharacterizing portion of claim 1 is based. WO-A2-2013/098377 discloses a housing for receiving an electronic unit of a motor vehicle which comprises a casing with a push fit cover carrying electrical connectors and the electronic unit. WO-A1-2014/188691 discloses a housing for an electronic control unit in which the electronic control unit and electrical connectors are provided on a cover which is connected to the housing by screws. JP-A-08236964 discloses a case for incorporating a printed circuit board in which the printed circuit board is held within the case by a fitting plate attached to a decorative cover plate.

An object of the present invention, which has been devised to solve these problems, is to provide a cover attachment structure of a case that allows a cover to be pressed (press-fitted) into a cover attachment rectangular frame of a case body without applying a considerably large force (load) while maintaining appropriate inward protruding lengths of engagement portions. With the cover attachment structure, after the cover has been pressed into and attached to the case body, the cover does not become loose and the risk of separation and removal of the cover can be reduced.

According to the present invention, there is provided a case having an electrical connector terminal for connection to a mating connector terminal, the case comprising a case body (101) and a cover and being as defined by claim 1.

The engagement portions may be disposed on mid-regions of the inner wall surfaces between corners of the cover attachment rectangular frame.

The cover attachment rectangular frame may be formed in such a way that, in a region between the cover attachment position and the opening, a distance between each of the two pairs of opposite inner wall surfaces gradually increases toward the opening.

The case body may have a tubular structure having a bottom, and the cover attachment rectangular frame may be located in a region of the tubular structure adjacent to the opening

The case body may be a case body for containing a circuit board, and the cover may be a cover having a connector terminal.

In the present invention, which is structured as described above, before the cover is attached to the rectangular frame, one of the distances in the vertical and horizontal directions between the opposite inner wall surfaces at the attachment position is smaller than the corresponding side-to-side dimension of the cover. That is, in the present invention, although the distance Wx between the opposite inner wall surfaces on which the engagement portions are disposed is greater than the corresponding side-to-side dimension Hx of the cover, the distance Wy between the opposite inner wall surfaces on which the engagement portions are not disposed is smaller than the corresponding side-to-side dimension Hy of the cover. Accordingly, in the state in which the cover is attached, the cover is attached so as to be firmly pressed in the direction of the side-to-side dimension Hy, and thereby looseness of the cover can be prevented. In the direction of the side-to-side dimension Hx, because the distance between the opposite inner wall surfaces is greater than the corresponding side-to-side dimension of the cover, the cover can be pressed into the case body without applying a considerably large force.

Moreover, because the distance Wy between the inner wall surfaces on which the engagement portions are not disposed is smaller than the corresponding side-to-side dimension Hy of the cover, in the state in which the cover is attached, the distance between the inner wall surfaces on which the engagement portions are disposed is reduced. Thus, in the state in which the cover is attached, the amount of structural engagement between the engagement portions and the cover can be increased. Therefore, even when an extraction force (in a direction opposite to the pressing direction) is applied to the cover, forward movement of the cover or separation of the cover can be reliably prevented. In the present invention, regarding the cover attachment rectangular frame before the cover is attached, the expression "the distance Wx between the opposite inner wall surfaces on which the engagement portions are disposed is greater than the corresponding side-to-side dimension Hx of the cover" means that there is a clearance between the cover and the rectangular frame in the direction of the distance Wx and the dimension Hx. The expression "the distance Wy between the opposite inner wall surfaces on which the engagement portions are not disposed is smaller than the corresponding side-to-side dimension Hy of the cover" means that the inner wall surfaces can firmly press the cover in the state in which the cover is pressed into the rectangular frame and attached to the cover attachment position.

As described above, in the present invention, the distance Wy between the opposite inner wall surfaces on which the engagement portions are not disposed is smaller than the corresponding side-to-side dimension Hy of the cover. Therefore, compared with a case where the distances between both pair of inner wall surfaces are greater than the corresponding side-to-side dimensions, a force needed to press the cover into the rectangular frame is increased. However, in the present invention, the distance Wx between the opposite inner wall surfaces on which the engagement portions are disposed is greater than the corresponding side-to-side dimension Hx of the cover. Thus, in the direction of the side-to-side dimension Hx, resistance against the cover is not particularly increased due to the presence of the engagement portions. Therefore, in total, a force needed to press the cover is not considerably increased. Moreover, in the state in which the cover is pressed into the cover attachment rectangular frame and attached to the cover attachment position, the cover is firmly pressed by the inner wall surfaces on which the engagement portions are not disposed. Furthermore, because the cover attachment rectangular frame is deformed so that the distance between the inner wall surfaces on which the engagement portions are disposed is reduced, the amount of engagement between the engagement portions and the edges of the cover becomes greater than the set dimension before the cover is attached. Thus, the risk of separation of the cover and the like can be reduced. As a result, the present invention provides advantages in that the cover can be pressed into the case body without applying a considerably large force, the cover can be attached to the case body without looseness, and the risk of separation or the like of the cover can be reduced.

Preferably, the engagement portions, which protrude or bulge inward, are disposed so that the distance between the engagement portions, which face each other, decreases from the opening toward the bottom. However, it is only necessary that, when the cover is pressed into the case body, the edges of the cover can pass over the engagement portions and the cover can be positioned at the cover attachment position. Accordingly, the shape of the inclined portions of the engagement portions or the distance between the engagement portions may be changed as appropriate in accordance with the amount of engagement between the engagement portions and the cover (edges of the cover). In the present invention, the term "substantially rectangular" means equilaterally quadrangular (substantially square) or inequilaterally quadrangular (substantially rectangular). Note that these terms do not refer to physically strict shapes but refer to apparent shapes. Accordingly, in a cross-sectional view of the four walls of the cover attachment rectangular frame, one pair of opposite sides (inner wall surfaces) may be convexly and gently rounded (arc-shaped) outward, and the other pair of opposite sides (inner wall surfaces) may be convexly and gently rounded inward, or both pairs of opposite sides may be convexly rounded outward or inward. In the present invention, the term "tubular or socket-shaped" refers not only to a shape that has a length greater than the inside diameter (corner-to-corner dimension or side-to-side dimension) thereof but also to a short tubular shape or a short socket-like shape.

As described above, preferably, the engagement portions are disposed on mid-regions of the inner wall surfaces between corners of the cover attachment rectangular frame. In this case, the engagement portions can be easily deformed. However, instead of disposing one engagement portion on one inner wall surface, each of the engagement portions may be divided into a plurality of sections. If the cross-sectional shape of the cover attachment rectangular frame is rectangular, preferably, the engagement portions are disposed on the inner wall surfaces along the long sides of the rectangle. However, in accordance with the ease of deforming the cover attachment rectangular frame, the engagement portions may be disposed on the inner wall surfaces along the short sides.

Preferably, in a state before the cover is pressed into the cover attachment rectangular frame (in a free state), a portion (inner peripheral surface) of the cover attachment rectangular frame adjacent to the opening has a rectangular shape having a size that allows the cover to be pressed into the cover attachment rectangular frame from the opening (open end) so that the cover can be attached by only pressing the cover. However, an appropriate external force may be applied to the cover attachment rectangular frame before inserting the cover to preliminarily deform the cover attachment rectangular frame. By doing so, the cover can be more easily inserted. As described above, preferably, the cover attachment rectangular frame is formed in such a way that, in a region between the cover attachment position and the opening, a distance between each of the two pairs of opposite inner wall surfaces gradually increases toward the opening. In this case, the cover can be pressed into the cover attachment rectangular frame more smoothly and easily. In the present invention, the shapes and the structures of the case body and the cover attachment rectangular frame of the case body may be appropriately determined in accordance with the use or the like of the case. As described above, preferably, the case body has a tubular structure having a bottom, and the cover attachment rectangular frame is located in a region of the tubular structure adjacent to the opening. The material of the cover attachment rectangular frame or the case body including the cover attachment rectangular frame may be selected from resins that have appropriate elasticity and toughness, which are, for example, a nylon resin (polyamide resin), such as PA66, or PBT resin.

### BRIEF DESCRIPTION OF THE DRAWINGS

Fig. 1 is a perspective view of a case body according to an embodiment of the present invention, before a cover is attached, and the cover;
Fig. 2 is a longitudinal sectional view of the case body before the cover is attached;
Fig. 3 illustrates a sectional view, taken along a line III-III in Fig. 2, and a partial enlarged view of the case body before the cover is attached;
Fig. 4 is a sectional view taken along a line IV-IV in Fig. 2 (showing a cross section passing through a cover attachment position);
Fig. 5 is a front (external) view illustrating the outer shape (outline) of the cover;
Fig. 6 is a schematic diagram illustrating, in an exaggerated manner, the relationships between the distances Wx and Wy between inner wall surfaces of the cover attachment rectangular frame at the cover attachment position before the cover is attached and the corresponding side-to-side dimensions Hx and Hy of the cover;
Fig. 7 illustrates a process of pressing the cover into the cover attachment rectangular frame of the case body in Fig. 2;
Fig. 8 illustrates a process of pressing the cover into the cover attachment rectangular frame of the case body in Fig. 3;
Fig. 9 is a longitudinal sectional view, corresponding to Fig. 2, and a partial enlarged view illustrating a cover attachment structure of the case;
Fig. 10 illustrates a longitudinal sectional view and a partial enlarged view, corresponding to Fig. 3, of the cover attachment structure of the case;
Fig. 11 is a schematic diagram illustrating, in an exaggerated manner, a modification in which the cross section of the cover attachment rectangular frame and the outline of the cover are changed from those of Fig. 6; and
Fig. 12 is a schematic diagram illustrating, in an exaggerated manner, a modification in which the cross section of the cover attachment rectangular frame and the outline of the cover are changed from those of Fig. 6.

### DESCRIPTION OF THE PREFERRED EMBODIMENTS

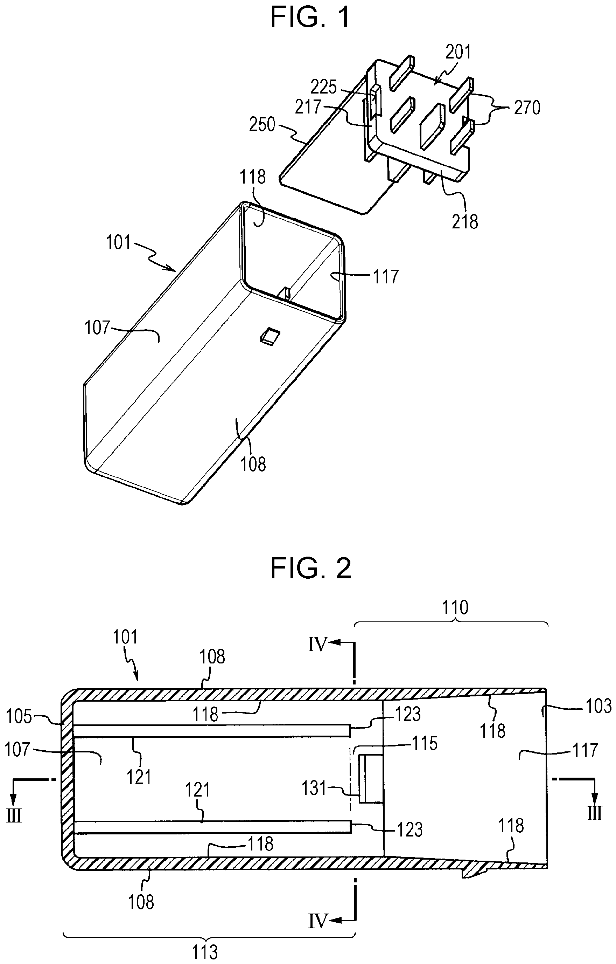

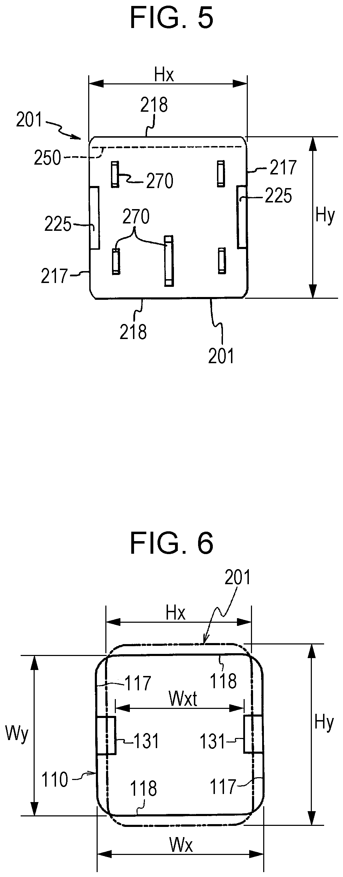

Referring to Figs. 1 to 10, an embodiment of the present invention will be described in detail. In the present embodiment, a case body is a case body for containing a circuit board, and a cover is a cover that has a connector terminal and that is integrated with the circuit board. As illustrated in the figures, a cover attachment structure of a case 100 according to the present embodiment includes a case body 101. The case body 101 has a tubular structure and has a substantially rectangular cross section that is close to a square cross section and that is substantially uniform in the front-back direction. The case body 101 is made of an elastically deformable resin (a plastic, which is, specifically, a nylon resin). The case body 101 has a quadrangular tubular structure and has an opening 103 at one end thereof, a bottom 105 at the other end thereof, and four flat walls 107 and 108 that form a tube. In the present specification, a direction from the middle of the case body 101 toward the opening 103 will be referred to as "forward" and a direction toward the bottom 105 will be referred to as "backward", and the corresponding sides will be referred to as "front side" and "back side". A cover 201 is made of an insulating material (such as a resin). As illustrated in Figs. 1, 5, and other figures, the cover 201 has a substantially rectangular (plate-like) shape with a substantially square outline. The cover 201 is configured so that it can close an inner cross section of the case body 101. In the present embodiment, the cover 201 is integrated with a circuit board 250. Connector terminals 270, which are electrically connected to terminals of the circuit board 250, protrude outward from the cover 201. The circuit board 250 is butt-joined and integrated with the cover 201 along one side of the rectangular outline of the cover 201 so as to extend perpendicular to the back surface of the cover 201.

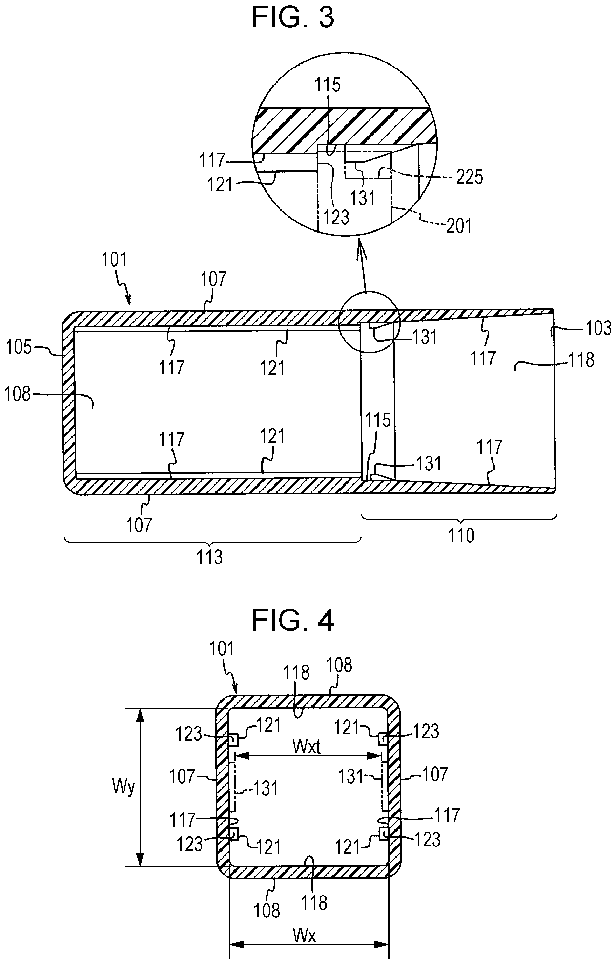

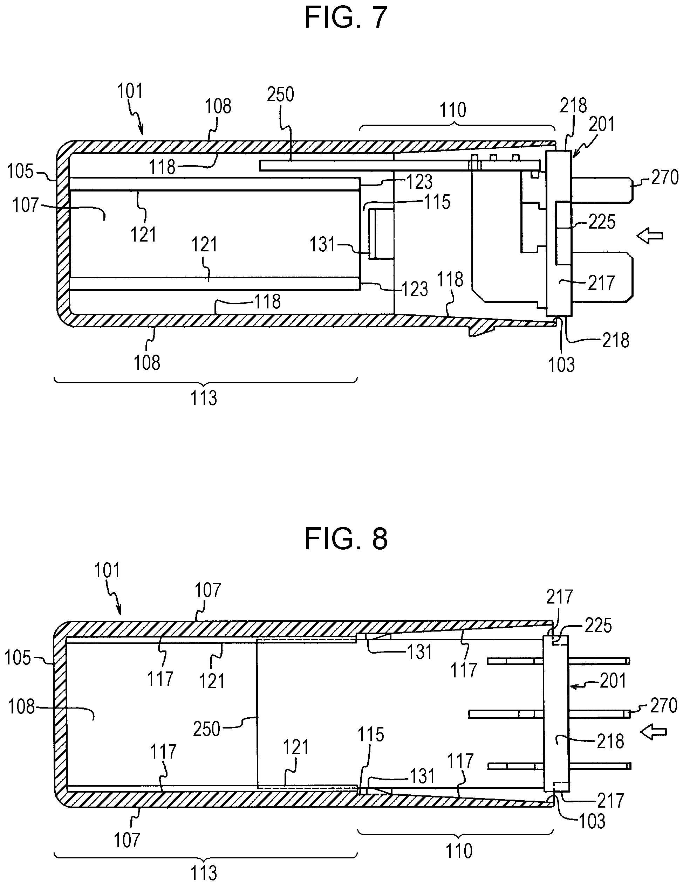

As illustrated in Figs. 2, 3, and other figures, approximately 1/3 of the case body 101 in the front-back direction (direction in which the tube extends) adjacent to an end thereof near the opening 103 (the right end in the figures, which is an open end) is a cover attachment rectangular frame 110, which is tubular or socket-shaped. The remaining portion of the case body 101, which is adjacent to the bottom 105 (the left end in the figures), is a board containing portion 113. A cover attachment position 115, which is a position to which the cover 201 is pressed and attached, is located at or near the back end of the cover attachment rectangular frame 110 (near the boundary between the board containing portion 113 and the cover attachment rectangular frame 110). Thus, the cover 201, which has a substantially rectangular shape corresponding to an inner cross section (defined by inner wall surfaces 117 and 118 of the four walls 107 and 108) of the cover attachment rectangular frame 110 (which may be also referred to as "the rectangular frame 110" or simply as "the frame 110") can be inserted from the opening 103 into the frame 110 and attached to the cover attachment position 115. In the present embodiment, the cover 201 is integrated with the circuit board 250 as described above. When the cover 201 is attached to the case body 101, the circuit board 250 is contained in the case body 101 so as to extend parallel to and located adjacent to one of the walls 108 of the case body 101 (see Fig. 7). For convenience of description, description of the circuit board 250 will be omitted as appropriate.

As described above, the case body 101, including the cover attachment rectangular frame 110, has a tubular structure having a substantially uniform rectangular cross section. In a region adjacent to the opening 103, the cover attachment rectangular frame 110 is formed so that the area of the inner cross section thereof gradually increases toward the opening 103 (see Figs. 2, 3, and other figures). That is, in a region adjacent to the opening 103, the cover attachment rectangular frame 110 is formed so that the distances between the opposite inner wall surfaces 117 and 118 of the walls 107 and 108 of the case body 101 (the vertical dimension and the horizontal dimension of the inner cross section of the case body 101) gradually increase and the area of the inner cross section gradually increases toward the opening 103. As a result, the thicknesses of the walls 107 and 108 of the cover attachment rectangular frame 110, which is tubular or socket-shaped, decrease toward the opening 103 in this region. In the (rectangular) cross section of the case body 101, the four corners of the inner wall surfaces 117 and 118 are concavely rounded (arc-shaped) over substantially the entire length of the case body 101 in the extension direction of the tube (see Fig. 4). Two linear protrusions 121 are disposed on each of the pair of opposite inner wall surfaces 117 in the board containing portion 113 of the case body 101 so as to bulge from the inner wall surfaces 117 and extend in the extension direction of the tube. The linear protrusions 121 are disposed symmetrically about the center, in the width direction, of a corresponding one of the inner wall surfaces 117 (the center of a side of the rectangular cross section) with a space therebetween. In the present embodiment, ends of the linear protrusions 121 (ends adjacent to the opening 103) are stoppers 123 that prevent the cover 201 from being excessively pressed into the case body 101. The stoppers 123 are located at the back end of the cover attachment rectangular frame 110, and the cover attachment position 115 is in a predetermined region in front of the stoppers 123 (between the stoppers 123 and the opening 103). Portions of the walls 107 and 108 between the stoppers 123 and the bottom 105 have thicknesses that are greater than those of portions of the walls 107 and 108 between the stoppers 123 and the opening 103.

The cover 201 has such vertical and horizontal (outline) dimensions that the cover 201 can close the opening 103 (cross section) at the cover attachment position 115 in the cover attachment rectangular frame 110. The cover 201 is a rectangular plate having two pairs of opposite sides 217 and 218. In the present embodiment, a portion of the rectangular frame 110 adjacent to the opening 103 has a cross section whose area gradually increases toward the opening 103. Thus, in a free state, the outer peripheral edge (sides) of the cover 201 can be inserted into the portion of the rectangular frame 110 adjacent to the opening 103 with a small clearance around the cover 201 (see Figs. 7 and 8). The corners of the cover 201 are convexly rounded so as to correspond to the four rounded corners of the inner wall surfaces 117 and 118 of the frame 110 (see Fig. 5).

As described above, the stoppers 123 in the present embodiment are the ends of the linear protrusions 121 on the inner wall surfaces 117 of the frame 110 of the case body 101. Engagement portions 131 are disposed on the inner wall surfaces 117 at positions between these ends (the stoppers 123) and the opening 103. The engagement portions 131 prevent forward movement or separation of the cover 201 that has been pressed into the case body 101 and attached to the cover attachment position 115. The engagement portions 131 are disposed on the pair of opposite inner wall surfaces 117, on which the linear protrusions 121 are disposed. Each of the engagement portions 131 is disposed on a corresponding one of the inner wall surfaces 117 at the midpoint between the linear protrusions 121 (the midpoint of a side of the rectangular cross section). As illustrated in Fig. 6 in an exaggerated manner, before the cover 201 is attached, the engagement portions 131 are disposed so as to protrude or bulge inward in such a way that the minimum distance Wxt between the engagement portions 131 is smaller than the corresponding side-to-side dimension Hx of the cover 201 (shown by a two-dot chain line). Each of the engagement portions 131 are disposed on a corresponding one of the inner wall surfaces 117 so that the center thereof is located at substantially the midpoint of the side of the rectangular cross section of the frame 110.

When the cover 201 is pressed into the rectangular frame 110 from the opening 103, the opposite sides 217 at the outer peripheral edge of the cover 201 pass over the engagement portions 131 while deforming the frame 110, and the cover 201 is stopped by the stoppers 123 and attached to the cover attachment position 115. In the state in which the cover 201 is attached, portions of the front surface of the cover 201 (facing the opening 103) adjacent to the opposite sides 217 engage with back surfaces of the engagement portions 131 facing the bottom 105. Thus, forward movement and separation of the cover 201 can be prevented. In the present embodiment, cut portions 225 (hook recesses) are formed in the thickness direction of the cover 201 in regions of the front surface of the cover 201 (facing the opening 103) adjacent to the opposite sides 217 (edges) so as to correspond to the engagement portions 131. In the state in which the cover 201 is attached, the engagement portions 131 are fitted to the cut portions 225 (hook recesses).

Next, referring to Figs. 4 to 6, the relationships between the distances between the opposite inner wall surfaces 117 and 118 at the cover attachment position 115 before the cover is attached to the rectangular frame 110 and the corresponding side-to-side dimensions of the cover 201 and the like will be described. The distance Wx (in the horizontal direction in the figures) between the opposite inner wall surfaces 117, on which the engagement portions 131 are disposed, is greater than the corresponding side-to-side dimension Hx of the cover 201 by, for example, 0.2 to 0.5 mm (see Fig. 6). The distance Wy (in the vertical direction in the figures) between the opposite inner wall surfaces 118, on which the engagement portions 131 are not disposed, is smaller than the corresponding side-to-side dimension Hy of the cover 201 by, for example, 0.2 to 0.5 mm. The differences between the distances and the side-to-side dimensions are determined on the basis of the magnitudes of the distances and the side-to-side dimensions, ease of deforming the case body 101, and the strength of the case body 101.

As described above, the engagement portions 131 are disposed so that the minimum distance Wxt therebetween is smaller than the corresponding side-to-side dimension Hx of the cover 201. In the present embodiment, the engagement portions 131 have the inclined portions so that the distance therebetween decreases toward the back end of the rectangular frame 110. Moreover, as described above, the inner wall surfaces 117 and 118 are inclined so that the distance therebetween increases toward the opening 103. The distances between portions of the opposite inner wall surfaces adjacent to the opening 103 in the vertical direction and in the horizontal direction are both greater than the corresponding side-to-side dimensions to the cover 201. Thus, the cover 201 can be pressed into the frame 110 so as to be clearance-fitted into the frame 110. In the present embodiment, the inclinations of the inner wall surfaces 117 and 118 start at positions between the protruding engagement portions 131 and the opening 103. These positions may be set at other position as appropriate, such as the positions of the engagement portions 131, in consideration of ease of pressing the cover 201.

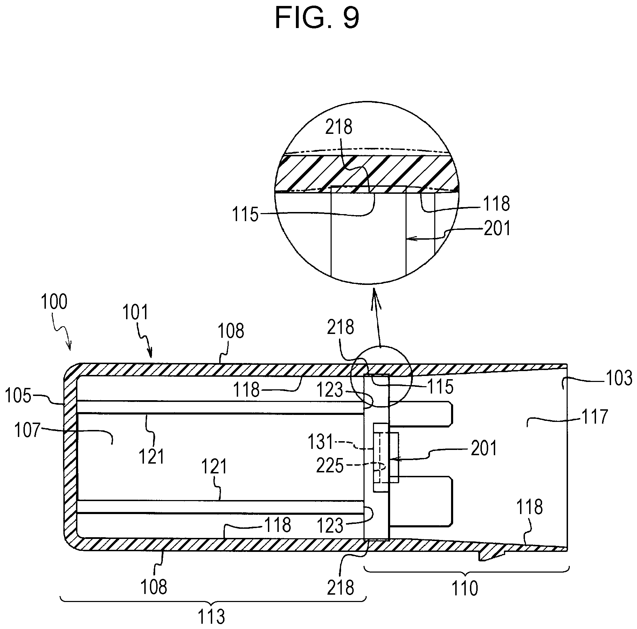

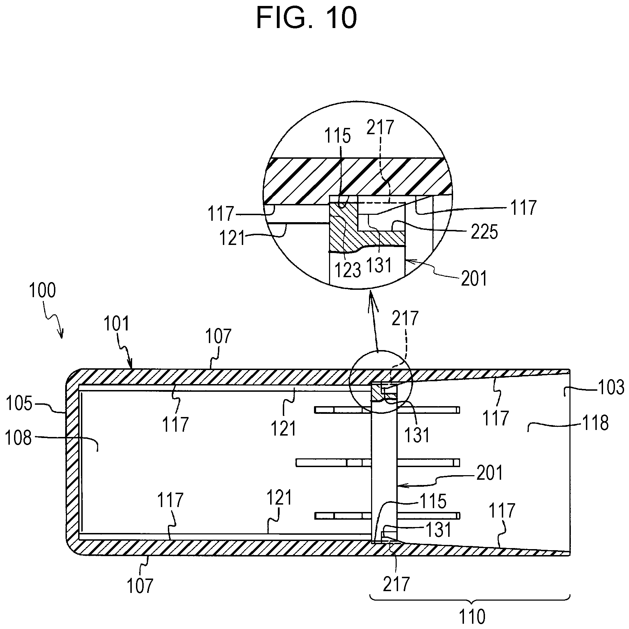

As illustrated in Figs. 7 and 8, in the present embodiment, which includes the case body 101 and the cover 201 described above, when the cover attachment rectangular frame 110 of the case body 101 is in a free state, the cover 201 is placed in a portion of the cover attachment rectangular frame 110 adjacent to the opening 103 after adjusting the orientation of the cover 201 so as to close the opening 103. In this state, the cover 201 is pressed into the case body 101 in the direction indicated by an arrow. By doing so, as illustrated in Figs. 9 and 10, the cover 201 is attached to the cover attachment position 115. That is, when the cover 201 is pressed into the case body 101, the following occurs. Portions of the opposite sides 217 at the outer peripheral edge of the cover 201, which are located at positions corresponding to the engagement portions 131 (in the horizontal direction in Figs. 4 to 6, hereinafter, in the horizontal direction), pass over the engagement portions 131 and are stopped by the stoppers 123. Portions of the opposite sides 218 at the outer peripheral edge of the cover 201, which are located at other positions (in the vertical direction in Figs. 4 to 6, hereinafter, in the vertical direction) deform the inner wall surfaces 118 of the rectangular frame 110 so as to increase the distance between the inner wall surfaces 118. Thus, the cover 201 is pressed into the case body 101 and attached to the cover attachment position 115 (see Figs. 9 and 10).

In the process of pressing the cover 201 into the case body 101, it is considered that deformation occurs specifically as follows. Until the cover 201 is stopped by the stoppers 123, the distance between the opposite inner wall surfaces 118 of the rectangular frame 110, which face each other in the vertical direction in Figs. 4 to 6, is increased by the edges of the cover 201 along the sides 218. As the distance between the opposite inner wall surfaces 118 is increased, the opposite inner wall surfaces 117 of the frame 110, which face each other in the horizontal direction, are deformed so that the distance therebetween is reduced. However, when the edges of the cover 201 are pressed against the engagement portions 131 on the frame 110 and until the edges of the cover 201 pass over the engagement portions 131, portions of the inner wall surfaces 117 of the frame 110 on which the engagement portions 131 are disposed and the surrounding portions are deformed so that the distance therebetween is increased. After the edges of the cover 201 have passed over the engagement portions 131, that is, when the cover 201 is stopped by the stoppers 123 and attached to the cover attachment position 115, due to the aforementioned relationship Wy < Hy, the distance, at the position 115, between the inner wall surfaces 118 is increased by the sides 218 of the cover 201, which face each other in the vertical direction, as shown by two-dot chain lines in Fig. 9.

As this distance is increased, the distance between the opposite inner wall surfaces 117 of the frame 110, on which the engagement portions 131 are disposed and which face each other in the horizontal direction (see Fig. 10), at the cover attachment position 115 is reduced so as to become smaller than that in an elastically returned state (the dimension Wx in a free state). Thus, in the state in which the cover 201 is pressed into the frame 110 and attached to the cover attachment position 115, the cover 201 is firmly pressed by the frame 110 in the vertical direction as the distance between the inner wall surfaces 118, which face each other in the vertical direction, is increased by the cover 201 as shown by two-dot chain lines in Fig. 9. Moreover, as the distance between the inner wall surfaces 118 is increased, the distance between the inner wall surfaces 117, which face each other in the horizontal direction, is reduced. As a result, the amount of engagement between each engagement portion 131 and a corresponding one of the sides 217 at the outer peripheral edge of the cover 201, which is shown in Fig. 10, can be made greater than (Hx - Wxt)/2, which is a set dimension before the cover 201 is attached.

As described above, in the present embodiment, because the distance Wy between the inner wall surfaces 118, on which the engagement portions 131 are not disposed, is smaller than the corresponding side-to-side dimension Hy of the cover 201, it is necessary to press the cover 201 into a space between the inner wall surfaces 118 with an increased force. However, because the distance Wx between the inner wall surfaces 117, on which the engagement portions 131 are disposed, is greater than the corresponding side-to-side dimension Hx of the cover 201, it is only necessary to press the cover 201 into a space between the inner wall surfaces 117 against a partial resistance (for increasing the distance) from portions of the inner wall surfaces 117 at which the engagement portions 131 are disposed and the surrounding portions. That is, according to the present invention, only the distance between the inner wall surfaces 118, on which the engagement portions 131 are not disposed, is made smaller than the corresponding side-to-side dimension of the cover 201 without making the distances between the inner wall surfaces both in the vertical and horizontal directions be smaller than the corresponding side-to-side dimensions of the cover 201. Therefore, it is not necessary to press the cover 201 with a considerably large force. Moreover, the cover 201 can be tightly held between the opposite inner wall surfaces 118, on which the engagement portions 131 are not disposed. Thus, looseness of the cover 201 can be prevented.

The opposite inner wall surfaces 117, on which the engagement portions 131 are disposed, generate resistance when the cover 201 passes over the engagement portions 131. However, after the cover 201 has been attached, because the distance between the inner wall surfaces 117 is reduced as compared with that before the cover is attached, the amount of engagement between the engagement portions 131 and the corresponding sides 217 of the cover 201 can be increased in accordance with the reduction in the distance. Therefore, the risk of separation and removal of the cover 201 can be considerably reduced. In particular, in the present embodiment, a mating (female) terminal connector of an external lead wire is plugged to the connector terminal 270 of the cover 201. Even if the mating terminal connector is unplugged with a large force in a maintenance operation or the like, the attachment structure can considerably reduce the risk of separation and removal of the cover. As a result, the cover 201 attachment structure of the case 100 according to the present embodiment, which has high vibration resistance and high impact resistance, is suitable for a case (housing) for containing an electronically controlled device (ECU) of an automobile.

In the present embodiment, because the engagement portions 131 are disposed on the mid-regions of sides of the rectangular shape of the cover attachment rectangular frame 110, the sides can be deformed in a balanced way. Thus, the cover 201 can be easily pressed into and securely attached to the cover attachment rectangular frame 110. The protruding lengths, the bulging lengths, and the like of the engagement portions 131 may be appropriately determined in consideration of a pressing force and ease of deforming the rectangular frame 110. In the present embodiment, in a region between the cover attachment position 115 and the opening 103, the distance between each of the two pairs of opposite inner wall surfaces 117 and 118 of the rectangular frame 110 increases toward the opening 103. Moreover, in a free state, the cover 201 can be inserted into a portion of the rectangular frame 110 adjacent to the opening 103. Thus, the cover 201 can be attached easily and smoothly.

It is not necessary to start pressing the cover 201 into the cover attachment rectangular frame 110 when the cover attachment rectangular frame 110 is in a free state. Alternatively, for example, the distance between the opposite inner wall surfaces 117, on which the engagement portions 131 are disposed, may be reduced by pressing the walls 107 from both sides, so that the distance between the opposite inner wall surfaces 118, on which the engagement portions 131 are not disposed, is increased. In this state, the cover 201 may be started to be pressed into the cover attachment rectangular frame 110. In the present embodiment, the engagement portions 131, which face each other, have inclined portions so that the distances therebetween decreases toward the bottom 105. Alternatively, the engagement portions 131 may be protrusions (protruding pieces or bulges) that do not have such inclined portions, as long as the engagement portions 131 can be deformed so that the cover 201 can be pressed into and attached to the case body 101 without generating a crack or the like in the engagement portions 131 and the like. For example, the difference between the corresponding side-to-side dimension Hy of the cover 201 and the distance Wy between the opposite inner wall surfaces 118 (in the vertical direction in the figures), on which the engagement portions 131 are not disposed, may be determined so that the cover 201 can be pressed into the case body 101 with an appropriate pressing force as described above. The difference between the corresponding side-to-side dimension Hx of the cover 201 and the distance Wx between the opposite inner wall surfaces 117 (in the horizontal direction in the figures), on which the engagement portions 131 are disposed, may be appropriately determined so that the amount of engagement between the outer peripheral edge of the cover 201 and the engagement portions 131 is increased appropriately. In this case, preferably, the clearance between the cover 201 and the inner wall surfaces 117 is as small as possible. The clearance may be zero.

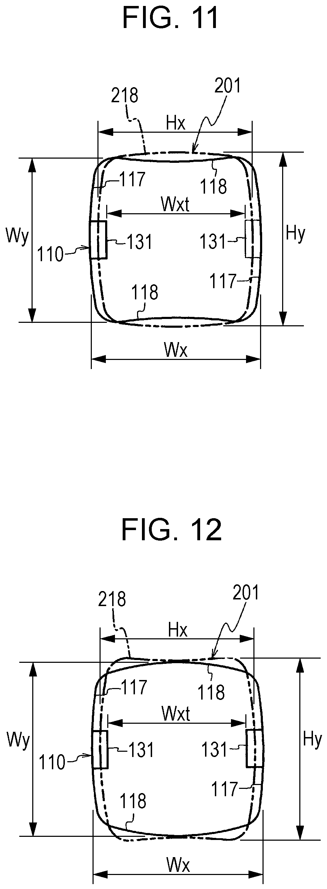

In the embodiment described above, the corners of the rectangular shape of the cover attachment rectangular frame 110 and the corners of the cover 201 are rounded. However, it is not necessary that these corners be rounded. As described above, in the present invention, regarding the cross-sectional shape of the cover attachment rectangular frame 110 and the shape of the cover 201, the term "substantially rectangular" refers to an apparently square or rectangular shape. Accordingly, as illustrated in Fig. 11 in an exaggerated manner, regarding the walls of the cover attachment rectangular frame 110, the opposite inner wall surfaces 117, on which the engagement portions 131 are disposed, may have arc-like shapes that are convexly and gently rounded so as to bulge outward from sides of the rectangular cross section, and the other pair of opposite inner wall surfaces 118 may have arc-like shapes that are concavely rounded so as to be recessed inward from sides of the rectangular cross section. In this case, for example, the sides 218 of the cover 201 (two-dot chain lines), which correspond to the inner wall surfaces 118 that are concavely rounded, may have convex arc-like shapes that bulge outward. Note that elements in Fig. 11 that coincide with or correspond to those in Fig. 6 are denoted by the same numerals. As a modification, as illustrated in Fig. 12 in an exaggerated manner, in the cross-sectional shape of the rectangular frame 110, both of the two pairs of opposite inner wall surfaces 117 and 118 may have convexly and gently rounded arc-like shapes budging outward from the sides of the rectangular cross-sectional shape. In this case, for example, the sides 218 of the cover 201 (two-dot chain line), which correspond to the inner wall surfaces 118, on which the engagement portions 131 are not disposed, may have concavely and gently rounded arc-like shapes that are recessed inward. That is, as illustrated in Figs. 11 and 12, the cross-sectional shape of the cover attachment rectangular frame 110 and the shape of the cover 201 each may be an apparently square or rectangular shape. In the cases where each side is rounded as illustrated in Figs. 11 and 12, Wx, Hx, Wy, and Hy are defined as the maximum values of distances and side-to-side dimensions.

In the present embodiment, the case body 101 has a tubular structure having a bottom and a uniform cross section, and the cover attachment rectangular frame 110 is disposed in a region adjacent to the opening 103. However, it is only necessary that a case body according to the present invention include a cover attachment rectangular frame that is tubular or socket-shaped, that has a substantially rectangular cross section, and that is elastically deformable. That is, as described above, it is only necessary that the case body have such a cover attachment rectangular frame as a part thereof. In other respects, the case body may have any appropriate shape or the like. The present invention can be applied not only to a case for an ECU, but also to a variety of cover attachment structures of cases.

## Claims

1. A case (100) having an electrical connector terminal for connection to a mating connector terminal, the case (100) comprising a case body (101) and a cover (201),
the case body (101) including a cover attachment rectangular frame (110) that is tubular or socket-shaped, that has a substantially rectangular cross section, and that is elastically deformable, a cover (201) attachment structure allowing the cover (201), which has a substantially rectangular outline, to be pressed into the cover attachment rectangular frame (110) from an opening (103) at an end of the cover attachment rectangular frame (110) by a predetermined distance and to be attached to a predetermined cover attachment position (115); and
engagement portions (131) that are disposed in the cover attachment rectangular frame (110) and that prevent forward movement and separation of the cover (201) attached to the cover attachment position (115),
wherein the engagement portions (131) protrude or bulge inward from one of two pairs of opposite inner wall surfaces (117, 118) of the cover attachment rectangular frame (110) in such a way that a minimum distance Wxt between the engagement portions (131) before the cover (201) is attached is smaller than a corresponding side-to-side dimension Hx of the cover (201),
**characterized by**:
a stopper (123) that is disposed in the cover attachment rectangular frame (110) and that prevents the cover (201) from being excessively pressed into the cover attachment rectangular frame (110); and in that:
in the cover attachment rectangular frame (110) before the cover (201) is attached, a distance Wx, at the cover attachment position (115), between the one of the two pairs of opposite inner wall surfaces (117) on which the engagement portions (131) are disposed is greater than the corresponding side-to-side dimension Hx of the cover (201), and a distance Wy, at the cover attachment position (115), between the other of the two pairs of opposite inner wall surfaces (118) on which the engagement portions (131) are not disposed is smaller than a corresponding side-to-side dimension Hy of the cover (201), and
wherein, in a state in which the cover (201) is pressed into the cover attachment rectangular frame (110) and attached to the cover attachment position (115), a distance between the opposite inner wall surfaces (118) on which the engagement portions (131) are not disposed is increased by the cover, and thereby the inner wall surfaces (118) firmly press the cover (201) and the cover attachment rectangular frame (110) is deformed so that a distance between the opposite inner wall surfaces (117) on which the engagement portions (131) are disposed is reduced.

2. A case (100) according to Claim 1,
wherein the engagement portions (131) are disposed on mid-regions of the inner wall surfaces (117) between corners of the cover attachment rectangular frame (110).

3. A case (100) according to Claim 1 or 2,
wherein the cover attachment rectangular frame (110) is formed in such a way that, in a region between the cover attachment position (115) and the opening (103), a distance between each of the two pairs of opposite inner wall surfaces (117, 118) gradually increases toward the opening (103).

4. A case (100) according to any one of Claims 1 to 3,
wherein the case body (101) has a tubular structure having a bottom (105), and the cover attachment rectangular frame (110) is located in a region of the tubular structure adjacent to the opening (103).

5. A case (100) according to any one of Claims 1 to 4,
wherein the case body (101) is a case body for containing a circuit board, and the cover (201) is a cover having a connector terminal.

6. A case according to claim 5 wherein the cover is integrated with a circuit board (250).

## Patentansprüche

1. Gehäuse (100) mit einem elektrischen Verbindungsanschluss zum Verbinden mit einem Gegenverbindungsanschluss, das Gehäuse (100) umfassend einen Gehäusekörper (101) und eine Abdeckung (201),
wobei der Gehäusekörper (101) einen rechteckigen Abdeckungsbefestigungsrahmen (110) enthält, der rohrförmig oder sockelförmig ist, der einen im Wesentlichen rechteckigen Querschnitt hat und der elastisch verformbar ist,
eine Befestigungsstruktur der Abdeckung (201), die der Abdeckung (201), die einen im Wesentlichen rechteckigen Umriss hat, ermöglicht, um einen vorbestimmten Abstand von einer Öffnung (103) an einem Ende des rechteckigen Abdeckungsbefestigungsrahmens (110) in den rechteckigen Abdeckungsbefestigungsrahmen (110) gedrückt zu werden, und an einer vorbestimmten Abdeckungsbefestigungsposition (115) befestigt zu werden; und
Eingriffsabschnitte (131), die in dem rechteckigen Abdeckungsbefestigungsrahmen (110) angeordnet sind und die eine vorwärts gerichtete Bewegung und eine Trennung von der Abdeckung (201), die an der Abdeckungsbefestigungsposition (115) befestigt ist, verhindern,
wobei die Eingriffsabschnitte (131) von einem aus zwei Paaren gegenüberliegender Innenwandflächen (117, 118) des rechteckigen Abdeckungsbefestigungsrahmens (110) auf eine solche Weise nach innen herausragen oder vorstehen, dass ein Mindestabstand Wxt zwischen den Eingriffsabschnitten (131), bevor die Abdeckung (201) befestigt wird, kleiner als eine entsprechende Seite-zu-Seite-Abmessung Hx der Abdeckung (201) ist,
**gekennzeichnet durch**:
einen Anschlag (123), der in dem rechteckigen Abdeckungsbefestigungsrahmen (110) angeordnet ist und der verhindert, dass die Abdeckung (201) übermäßig in den rechteckigen Abdeckungsbefestigungsrahmen (110) gedrückt wird; und **dadurch, dass**:
in dem rechteckigen Abdeckungsbefestigungsrahmen (110), bevor die Abdeckung (201) befestigt wird, ein Abstand Wx an der Abdeckungsbefestigungsposition (115) zwischen dem einen der zwei Paare gegenüberliegender Innenwandflächen (117), an dem die Eingriffsabschnitte (131) angeordnet sind, größer als die entsprechende Seite-zu-Seite-Abmessung Hx der Abdeckung (201) ist, und ein Abstand Wy an der Abdeckungsbefestigungsposition (115) zwischen dem anderen der zwei Paare gegenüberliegender Innenwandflächen (118), an dem die Eingriffsabschnitte (131) nicht angeordnet sind, kleiner als die entsprechende Seite-zu-Seite-Abmessung Hy der Abdeckung (201) ist, und
wobei in einem Zustand, in dem die Abdeckung (201) in den rechteckigen Abdeckungsbefestigungsrahmen (110) gedrückt ist und an der Abdeckungsbefestigungsposition (115) befestigt ist, ein Abstand zwischen den gegenüberliegenden Innenwandflächen (118), an denen die Eingriffsabschnitte (131) nicht angeordnet sind, durch die Abdeckung erhöht wird, und wodurch die Innenwandflächen (118) die Abdeckung (201) festdrücken und der rechteckige Abdeckungsbefestigungsrahmen (110) verformt wird, sodass ein Abstand zwischen den gegenüberliegenden Innenwandflächen (117), an denen die Eingriffsabschnitte (131) angeordnet sind, verringert wird.

2. Gehäuse (100) nach Anspruch 1,
wobei die Eingriffsabschnitte (131) an Mittelbereichen der Innenwandflächen (117) zwischen Ecken des rechteckigen Abdeckungsbefestigungsrahmens (110) angeordnet sind.

3. Gehäuse (100) nach Anspruch 1 oder 2,
wobei der rechteckige Abdeckungsbefestigungsrahmen (110) auf eine solche Weise gebildet ist, dass in einem Bereich zwischen der Abdeckungsbefestigungsposition (115) und der Öffnung (103) ein Abstand zwischen jedem der Paare gegenüberliegender Innenwandflächen (117, 118) zur Öffnung hin (103) allmählich zunimmt.

4. Gehäuse (100) nach einem der Ansprüche 1 bis 3,
wobei der Gehäusekörper (101) eine rohrförmige Struktur mit einem Boden (105) hat und der rechteckige Abdeckungsbefestigungsrahmen (110) in einem Bereich der rohrförmigen Struktur benachbart zu der Öffnung (103) angeordnet ist.

5. Gehäuse (100) nach einem der Ansprüche 1 bis 4,
wobei der Gehäusekörper (101) ein Gehäusekörper zum Enthalten einer Leiterplatte ist und die Abdeckung (201) eine Abdeckung mit einem Verbindungsanschluss ist.

6. Gehäuse nach Anspruch 5, wobei die Abdeckung mit einer Leiterplatte (250) integriert ist.

## Revendications

1. Boîtier (100) présentant un contacteur de connecteur électrique en vue d'une connexion à un contacteur de connecteur complémentaire, le boîtier (100) comprenant un corps de boîtier (101) et un couvercle (201),
le corps de boîtier (101) comprenant un cadre rectangulaire de fixation de couvercle (110) qui est tubulaire ou en forme de douille, qui présente une section transversale sensiblement rectangulaire et qui est élastiquement déformable, une structure de fixation de couvercle (201) permettant au couvercle (201), qui présente un contour sensiblement rectangulaire, d'être pressé dans le cadre rectangulaire de fixation de couvercle (110) depuis une ouverture (103) au niveau d'une extrémité du cadre rectangulaire de fixation de couvercle (110) d'une distance prédéterminée et d'être fixé à une position de fixation de couvercle prédéterminée (115) ; et
des parties de prise (131) qui sont disposées dans le cadre rectangulaire de fixation de couvercle (110) et qui empêchent un mouvement vers l'avant et la séparation du couvercle (201) fixé à la position de fixation de couvercle (115),
les parties de prise (131) faisant saillie ou étant bombées vers l'intérieur depuis une de deux paires de surfaces de paroi interne opposées (117, 118) du cadre rectangulaire de fixation de couvercle (110) de manière qu'une distance minimale Wxt entre les parties de prise (131) avant que le couvercle (201) ne soit fixé est inférieure à une dimension latérale correspondante Hx du couvercle (201),
**caractérisé par** :
une butée (123) qui est disposée dans le cadre rectangulaire de fixation de couvercle (110) et qui empêche au couvercle (201) d'être excessivement pressé dans le cadre rectangulaire de fixation de couvercle (110) ; et en ce que :
dans le cadre rectangulaire de fixation de couvercle (110) avant que le couvercle (201) ne soit fixé, une distance Wx, au niveau d'une position de fixation de couvercle (115), entre l'une des deux paires de surfaces de paroi interne opposées (117) sur lesquelles les parties de prise (131) sont disposées est supérieure à la dimension latérale correspondante Hx du couvercle (201) et une distance Wy, au niveau de la position de fixation de couvercle (115), entre l'autre des deux paires de surfaces de paroi interne opposées (118) sur lesquelles les parties de prise (131) ne sont pas disposées est inférieure à une dimension latérale correspondante Hy du couvercle (201), et
dans un état dans lequel le couvercle (201) est pressé dans le cadre rectangulaire de fixation de couvercle (110) et fixé à la position de fixation de couvercle (115), une distance entre les surfaces de paroi interne opposées (118) sur lesquelles les parties de prise (131) ne sont pas disposées est augmentée par le couvercle, et ainsi les surfaces de paroi interne opposées (118) pressent fermement le couvercle (201) et le cadre rectangulaire de fixation de couvercle (110) est déformé de manière qu'une distance entre les surfaces de paroi interne opposées (117) sur lesquelles les parties de prise (131) sont disposées est réduite.

2. Boîtier (100) selon la revendication 1 ;
dans lequel les parties de prise (131) sont disposées sur des régions médianes des surfaces de paroi interne (117) entre des coins du cadre rectangulaire de fixation de couvercle (110).

3. Boîtier (100) selon la revendication 1 ou 2,
dans lequel le cadre rectangulaire de fixation de couvercle (110) est formé de manière que, dans une région entre la position de fixation de couvercle (115) et l'ouverture (103), une distance entre chacune des deux paires de surfaces de paroi interne opposées (117, 118) augmente progressivement vers l'ouverture (103).

4. Boîtier (100) selon l'une quelconque des revendications 1 à 3,
dans lequel le corps de boîtier (101) présente une structure tubulaire comportant un fond (105), et le cadre rectangulaire de fixation de couvercle (110) est situé dans une région de la structure tubulaire adjacente à l'ouverture (103).

5. Boîtier (100) selon l'une quelconque des revendications 1 à 4, dans lequel le corps de boîtier (101) est un corps de boîtier destiné à contenir une carte de circuit, et le couvercle (201) est un couvercle présentant un contacteur de connecteur.

6. Boîtier selon la revendication 5, dans lequel le couvercle est intégré à une carte de circuit (250).
